# EUROPÄISCHE PATENTSCHRIFT

(11) **EP 1 034 214 B1**
(45) Veröffentlichungstag und Bekanntmachung des Hinweises auf die Patenterteilung: **16.06.2004**
(21) Anmeldenummer: 98965063.5
(22) Anmeldetag: 03.11.1998
(51) Int. Cl.: C08K 7/22, C08K 3/10, C08K 13/00, H05K 9/00

(54) **KUNSTSTOFFMATERIAL UND LEITFÄHIGER KUNSTSTOFFGEGENSTAND**
PLASTIC MATERIAL AND CONDUCTIVE PLASTIC OBJECT
MATERIAU EN MATIERE PLASTIQUE ET ARTICLE EN MATIERE PLASTIQUE CONDUCTEUR

(30) Priorität: 03.11.1997 DE 19749955
(43) Veröffentlichungstag der Anmeldung: 13.09.2000
(73) Patentinhaber: Kahl, Helmut, 12307 Berlin (DE); Tiburtius, Bernd, 14532 Kleinmachnow (DE); Gielnik, Karl, 12249 Berlin (DE)
(72) Erfinder: Kahl, Helmut, 12307 Berlin (DE); Tiburtius, Bernd, 14532 Kleinmachnow (DE); Gielnik, Karl, 12249 Berlin (DE)
(74) Vertreter: Keussen, Christof, Dr.
(86) Internationale Anmeldenummer: PCT/DE1998/003280
(87) Internationale Veröffentlichungsnummer: WO 1999/023153

(56) Entgegenhaltungen:
- EP-A- 0 398 672
- EP-A- 0 779 629
- WO-A-86/03995

## Beschreibung

Die Erfindung betrifft ein Kunststoffmaterial gemäß dem Oberbegriff des Anspruchs 1 sowie einen aus diesem Material gefertigten leitfähigen Kunststoffgegenstand, insbesondere ein Dichtungs- und Abschirmprofil.

Elektrisch leitfähige Dichtungsmaterialien auf Silicon-Basis mit leitfähiger Füllung zur Herstellung von Gehäusedichtungen mit elektromagnetischer Abschirmwirkung an Ort und Stelle ("mold-in-place gaskets" = MIPG bzw. "form-in place gaskets" = FIPG) sind bekannt.

Sie wurden bis Anfang der neunziger Jahre insbesondere zum verklebenden Abdichten der Einzelteile von Abschirmgehäusen oder zum Aufkleben vorgefertiger Abschirmdichtungen während der Gehäusemontage eingesetzt und in ihren Eigenschaften entsprechend eingestellt. Zu entsprechenden Produkten wird auf das Datenblatt CS-723 "Conductive Caulking Sytems" (1972) der Fa. Tecknit, USA, das Technical Bulletin 46 "CHO-BOND 1038" (1987) der Fa. Comerics, USA, sowie die DE-A-39 36 534 hingewiesen.

Aus der DE-A-39 34 845 ist eine mehrteilige Abschirmdichtung bekannt, die aus einem elastischen Träger und einer hoch leitfähigen Deckschicht besteht und sowohl eine Vorfertigung von Gehäuseteilen mit Dichtung vor der Montage als auch ein wiederholtes Öffnen des Gehäuses nach dem erstmaligen Verschließen erlaubt. Mit diesem Aufbau soll speziell den Inhomogenitätsproblemen begegnet werden, die aufgrund des hohen spezifischen Gewichts der die Leitfähigkeit des Materials erbringenden Metallteilchen auftreten. Die Herstellung der mehrkomponentigen Dichtung ist aber aufwendig.

Es hat sich daher in der Massenproduktion das Verfahren nach der EP-B-0 629 114 durchgesetzt, bei dem das leitfähige Material in einem pastösen Ausgangszustand derart mittels Druck aus einer Nadel oder Düse direkt auf ein Gehäuseteil aufgebracht wird und sich dort unter Anhaften an dessen Oberfläche elastisch verfestigt, daß sich (formgeberfrei) ein zugleich leitfähiges und elastisches Abschirmprofil ausbildet. Dessen Profilgestalt wird über die geeignete Wahl der Querschnittsform und -größe und Abtastgeschwindigkeit der Nadel bzw. Düse sowie durch die Einstellung der Materialeigenschaften wie Viskosität, Thixotropie und Erhärtungs- bzw. Vernetzungsgeschwindigkeit vorbestimmt.

WO-A-86/03995 offenbart Abschirmmaterialien, die für elektrische Apparate eingesetzt werden können. Die Materialien umfassen eine Harzmatrix und hohle Mikrokugeln, die aus Flugasche hergestellt sind. Die Mikrokugeln können teilweise auch von einer metallischen Hülle umhüllt sein.

EP-A-0 779 629 offenbart elektrisch leitfähige Zusammensetzungen auf Basis einer Polytetrafluorethylen-Matrix, in die als elektrisch leitfähige Partikel bei-. spielsweise mit Metall umhüllte Glasblasen eingearbeitet sein können.

Als Füllstoffe werden bei bekannten hoch leitfähigen Dichtungsmassen insbesondere massive Edelmetallpartikel, etwa aus Silber, edelmetallbeschichtete Teilchen mit unedlem Kern, wie etwa Ag- oder Pt-beschichtete Cu- oder Ni-Teilchen, Verbunde aus unedlen Metallen, wie etwa Nibeschichtete: Cu-Teilchen, oder auch edelmetallbeschichtete Glas- oder Keramikteilchen eingesetzt. Die ebenfalls bekannten Füllstoffe auf Kohlenstoffbasis werden in ihrer Leitfähigkeit heutigen Anforderungen nicht gerecht.

Im Zuge des fortschreitenden Masseneinsatzes und der sinkenden Preise von elektronischen Geräten, die nur mit hochwirksamer Abschirmung sicher funktionieren, unterliegt die Herstellung von Abschirmgehäusen einem hohen Kostendruck, der unter anderem zur Suche nach kostengünstigen und dennoch leicht zu verarbeitenden und in ihren Eigenschaften variabel einstellbaren Dichtungsmaterialien zwingt, die zuverlässig wirksame Abschirmprofile ergeben.

Der Erfindung liegt deshalb die Aufgabe zugrunde, ein solches verbessertes Kunststoffmaterial bzw. einen elektrisch leitfähigen Kunststoffgegenstand anzugeben.

Die. Aufgabe wird durch ein Kunststoffmaterial mit den im Anspruch 1 angegebenen Merkmalen bzw. einen. leitfähigen Kunststoffgegenstand mit den Merkmalen des Anspruchs 12 gelöst.

Die Erfindung schließt den grundlegenden Gedanken ein, das Ausgangsmaterial für einen leitfähigen Kunststoffgegenstand als Kunstharzmatrix mit eingelagerten formelastisehen Mikro-Hohlkörpern und folglich mit geringer Dichte und hoher Elastizität auszubilden. Das Material enthält insbesondere einen leitfähigen Füllstoff; in einer alternativen Ausführung kann die Leitfähigkeit des fertigen thermo- oder duroplastischen Kunststoffgegenstandes aber durch eine mindestens partielle leitfähige Beschichtung erzeugt oder erhöht werden.

Die Wandung der Mikro-Hohlkörper weist ferner einen Kunststoff auf und ist im wesentlichen gasdicht, was zusammen den erwünschten hohen Grad an Formelastizität, insbesondere elastischer Kompressibilität, der Füllkörper ergibt.

In einer bevorzugten Ausgestaltung liegt mindestens ein Teil des metallischen Füllstoffs als metallische Hülle bzw. Beschichtung der Mikro-Hohlkörper vor, so daß die Leitfähigkeit des Gesamtmaterials (Matrix mit Füllung) zumindest zu einem erheblichen Teil über den Kontakt der leitfähigen Wandungen der Hohlkörper erzielt wird.

Sofern der metallische Füllstoff im wesentlichen allein als Hülle der Mikro-Hohlkörper vorliegt, erfordert dieser Mechanismus einen relativ hohen Grad an Füllung mit den Hohlkörpern, damit sich über einen zu erzeugenden Dichtungsquerschnitt eine hinreichend größe Dichte an Strompfaden über die Wandungskontakte ausbilden kann. Der Füllungsgrad ist dabei um so höher einzustellen, je glatter die Oberfläche der leitfähigen Beschichtung ist.

Wenn die metallische Beschichtung aber eine rauhe Oberfläche, insbesondere mit einer im wesentlichen radial ausgerichteten Kristallitstruktur, hat, kann man indes vorteilhafterweise mit mäßig hohen Füllungsgraden auskommen und erreicht zudem einen besonders stabilen Zusammenhalt zwischen Matrix und Füllkörpern.

Wenn der metallische Füllstoff allerdings in einer anderen Fortbildung des Erfindungsgedankens im wesentlichen in der herkömmlichen Weise als Metallpulver in die Matrix dispergiert ist, sollte der Grad an Füllung mit den (dann nicht leitfähigen und folglich isolierende Bereiche bildenden) Mikro-Hohlkörpern nicht zu hoch sein.

Die Mikro-Hohlkörper haben zweckmäßigerweise einen Durchmesser im Bereich zwischen 5 µm und 100 µm, insbesondere zwischen 15 µm und 50 µm.

In einer technologisch einfach zu realisierenden Variante, die eine elektrisch und mechanisch isotrope Kunststoffmasse ergibt, ist mindestens ein Teil der Mikro-Hohlkörper hohlkugelförmig. Spezielle Eigenschaften - etwa Thixotropie und elektrische wie mechanische Anisotropie - lassen sich erreichen, wenn mindestens ein Teil der Mikro-Hohlkörper eine annähernd ellipsoidische, zylindrische oder prismatische Gestalt (auch eine brikettartige Gestalt oder Flake-Form) aufweist, wobei die Länge der größten Hauptachse eines Ellipsoids mindestens das 1,5-fache der nächstgrößeren Hauptachse bzw. die Zylinderhöhe mindestens das 1,5-fache des Radius bzw. die Höhe des Prismas mindestens das 1,5-fache der Länge von dessen größter Grundflächenseite beträgt. Speziell beim Austrag eines solchen Materials aus einer Nadel oder Düse oder auch bei einem Rakel-Auftrag kann nämlich durch die dynamischen Grenzflächen-Orientierungseffekte eine Ausrichtung der länglichen Mikro-Hohlkörper erfolgen, und eine anschließende Verfestigung an der Unterlage konserviert diese Ausrichtung.

Die Mikro-Hohlkörper können im Inneren auch durch Zwischenwandungen unterteilt bzw. aus mehreren separaten Hohlräumen aufgebaut sein.

Die metallische Hülle umfaßt vorzugsweise die gesamte Oberfläche der Mikro-Hohlkörper und ergibt damit insbesondere Gasdichtigkeit und somit elastische Kompressibilität mit hoher und über lange Zeit praktisch konstanter Rückstellkraft. Sie hat eine mittlere Dicke im Bereich zwischen 0,1 µm und 5 µm, die auf die Abmessungen der Mikro-Hohlkörper so abgestimmt ist, daß die effektive Dichte der beschichteten Mikro-Hohlkörper nicht wesentlich größer als die der Kunststoffmatrix ist.

Auf die beschriebene Weise wird zwei Hauptnachteilen von mit massivem Metallpulver gefüllten Kunststoffmassen - der hohen Sedimentationsneigung und dem begrenzten "compression set" - höchst wirkungsvoll abgeholfen und eine ausgezeichnete Lagerfähigkeit und leichte mechanische Verarbeitbarkeit erreicht.

Ein entsprechender Kunststoffgegenstand - speziell ein Abschirmprofil, das freitragend durch Aufbringen eines Dichtungsmaterials dieser Art auf eine Fläche eines Abschirmgehäuseteils gebildet ist - hat mithin eine nahezu ideal homogene Verteilung der Mikro-Hohlkörper in der Kunstharzmatrix und eine gleichmäßg hohe Elastizität und Formbeständigkeit.

Die Oberfläche der metallischen Hülle der Mikro-Hohlkörper ist bevorzugt rauh oder porös, bis hin zu stark strukturierten Beschichtungen mit kristallitartigen, weitgehend radial ausgerichteten Fortsätzen, die eine innige Verbindung mit einer Matrix und - über ein regelrechtes Miteinander-Verhaken der in der Matrix zueinander benachbarten Hohlkörper - eine hohe Volumenleitfähigkeit auch bei relativ niedrigem Füllungsgrad sichern.

Besonders hohe Materialkosteneinsparungen sind bei einer Ausführung möglich, bei der die metallische Hülle aus mindestens zwei Schichten besteht, wobei nur die äußere eine Edelmetallschicht ist.

Die leitfähige Hülle mit den erwähnten Vorzugsmerkmalen auf die Mikro-Hohlkörper ist in einem an sich bekannten elektrodenlosen ("electroless") oder galvanischen Verfahren oder auch in einem Vakuumverfahren, speziell durch Bedampfen oder Aufsputtern, erzeugt.

Zur Bildung relativ weicher, eine gewisse Plastizität aufweisender Abschirmprofile wird vorteilhafterweise eine Siliconmatrix mit einem Anteil von nicht oder schwach vernetzendem Siloxan von mehr als 3 Masse-% eingesetzt.

Die Beimischung eines als solchen nicht-vernetzenden längerkettigen Siloxans ergibt für die Matrix nach Aushärtung der vernetzbaren Siliconkomponente (durch Luftfeuchtigkeit, Wärme oder Strahlung) eine weitmaschig vernetzte Struktur mit einer gewissen Plastizität, deren Grad über das Mischungsverhältnis vorbestimmt werden kann. Zur Bildung hochgradig plastischer Dichtungen für spezielle Anwendungen, die aber aufgrund der eingelagerten formelastischen Hohlkugeln dennoch ausreichende Elastizität aufweisen, kann der Anteil der nicht-vernetzenden Komponente bis zu einem Vielfachen des Anteils der vernetzbaren Komponente erhöht sein.

Die wahlweise zusätzliche Zugabe eines organischen Lösungsmittels dient zum einen der Opimierung der Verarbeitungseigenschaften des Materials und kann zum anderen die Gebrauchseigenschaften des fertigen Profils positiv beeinflussen. Sie bewirkt gewissermaßen ein "Aufschwemmen" des Matrixmaterials, erleichtert insbesondere das Mischen der Komponenten und verbessert die Benetzung. Gute Ergebnisse wurden mit Anteilen zwischen 5 und 20 Masse-% Benzin und/oder Toluol erzielt.

Ein entsprechendes Abschirmprofil kann leicht einen Deformationsgrad von über 30%, insbesondere von über 50%, bezogen auf die Höhe eines unbelasteten U-förmigen Dichtungsprofils aus Vollmaterial, haben.

Die Matrix kann aber auch durch eine Zwei-Komponenten-Epoxidharz- oder Polyurethanmischung oder sonstige vernetzende oder thermoplastische Kunststoffe gebildet sein.

Durch die genannten materialseitigen und ggfs. zusätzlichen konstruktiven Maßnahmen - insbesondere die Vorgabe einer geeignet biegeelastischen oder kompressiblen Querschnittsform des Profils - lassen sich auch Gehäusefugen mit über den Längsverlauf erheblich differierender Breite zuverlässig abschirmend abdichten. Dies erlaubt beispielsweise kostengünstig größere Toleranzen bei der Herstellung der Gehäuse.

Vorteilhafte Weiterbildungen der Erfindung sind im übrigen in den Unteransprüchen gekennzeichnet bzw. werden nachstehend im Rahmen der Beschreibung bevorzugter Ausführungen der Erfindung unter Bezugnahme auf die Figuren näher dargestellt. Es zeigen:
- Figur 1: eine schematische Querschnittsdarstellung durch ein Abschirmprofil gemäß einer ersten Ausführungsform,
- Figur 2: eine schematische Querschnittsdarstellung durch ein Abschirmprofil gemäß einer weiteren Ausführungsform und
- Figur 3: eine schematische Querschnittsdarstellung durch ein Abschirmprofil gemäß einer weiteren Ausführungsform.

Für ein erstes Ausführungsbeispiel der Erfindung wird mit der nachfolgenden Tabelle als Mischung 1 ein elektrisch leitfähiges Material für die Matrix angegeben, das ein wärmehärtendes Einkomponentensystem darstellt. Dieses nach dem Aushärten elastische, aber relativ weiche Material eignet sich für die Erzeugung von Abschirmprofilen an Gehäusekanten wiederverschließbarer EMI-Gehäuse mit mäßigen Fertigungstoleranzen.

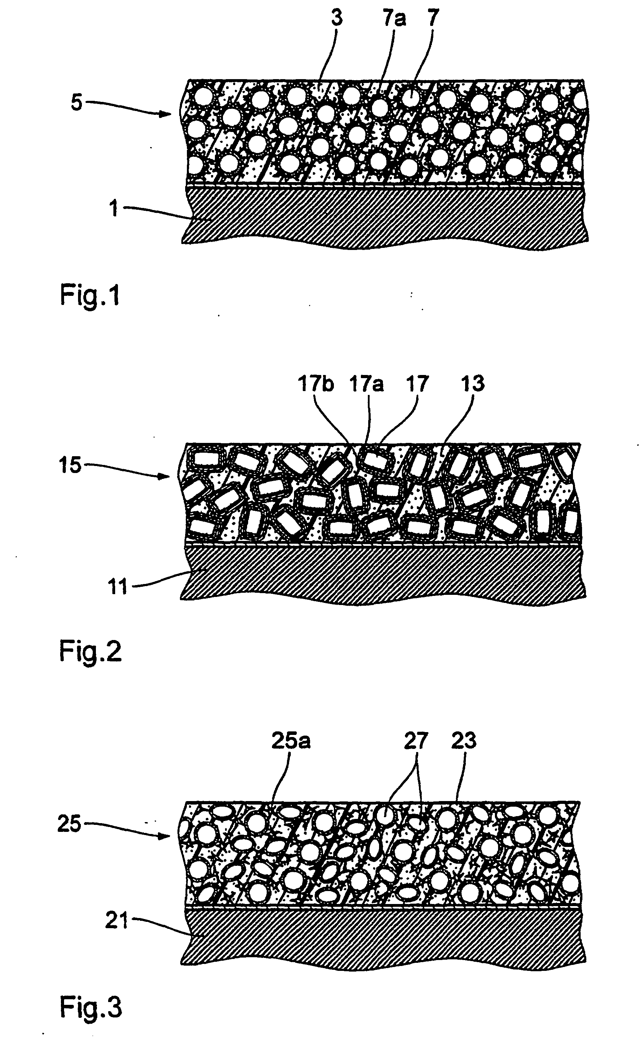

Wie Fig. 1 zu entnehmen ist, ist dieses Material für die Matrix 5 einer auf einem Gehäuseabschnitt 1 gebildeten Abschirmdichtung 3 mit PVDC(Polyvinylidenchlorid)-Hohlkugeln 7 mit einem mittleren Durchmesser von ca. 20 µm mit einer stark kristallartig strukturierten Ag-Beschichtung 7a mit einer mittleren Dicke von ca. 1 µm in einem Volumenverhältnis von 1:1 gefüllt.

| Mischung 1 | | |
|---|---|---|
| | | Anteil (Masse-%) |
| Komponente I | Silicon "TSE 3220" der Fa. GE | 32,4 |
| II | Polydimethylsiloxan mit Methyl-oder Hydroxylendgruppen (dyn. Visk. 20 ... 500 mPa.s) | 10,7 |
| III | Siliconharzlösung GE "PSA 529" | 19,5 |
| IV | Toluol | 16,3 |
| V | Benzin | 21,1 |

Für ein zweites Ausführungsbeispiel wird als Mischung 2 ein elektrisch leitfähiges Kunststoffmaterial angegeben, dessen Matrixmaterial ein raumtemperaturhärtendes Zweikomponentensystem darstellt. Das aus diesem Material gebildete Abschirmprofil hat einen hohen Deformationsgrad, zeigt deutliche Plastizität und eignet sich besonders zum Abdichten von Spalten in EMI-Abschirmgehäusen mit erheblichen Fertigungstoleranzen.

| Mischung 2 | | |
|---|---|---|
| Komponente I/A | Silicon GE "SLE 5300 A" | 53,3 |
| I/B | Silicon GE "SLE 5300 B" | 5,3 |
| II | Polydimethylsiloxan mit Methylendgruppen (Visk. ca. 50 mPa-s) | 20,7 |
| III | Toluol | 20,7 |

Wie Fig. 2 zeigt, ist dieses Matrixmaterial 15 für eine Abschirmdichtung 13 auf einem Gehäuseabschnitt 11 mit annähernd quaderförmigen ACN(Acrylnitril)-Hohlkörpern 17 mit einer Beschichtung aus einer Ni-Schicht 17a und einer darüberliegenden porösen Ag-Schicht 17b mit einer Gesamtdikke von ca. 2 µm in einem Verhältnis von etwa 1 Volumenteil Matrix und 2 Volumenteilen Füllkörpern gefüllt, und die Gesamtmischung hat aufgrund der anisotropen Gestalt der Füllkörper anisotrope mechanische sowie elektrische Eigenschaften.

Als drittes Ausführungsbeispiel wird als Mischung 3 ein warmhärtendes Einkomponentensystem entsprechend dem ersten Beispiel angegeben, bei dem die leitfähige Komponente als Pulver aus kristallitischen, sternförmigen oder flakeartigen Teilchen mit relativ großer Oberfläche bzw. als Mischung aus Teilchen mit solchen Formen in der Matrix enthalten ist.

| Mischung 3 | | |
|---|---|---|
| | | Anteil (Masse-%) |
| Komponente I | Silicon "TSE 3220" der Fa. GE | 13,6 |
| II | Polydimethylsiloxan mit Methyl-oder Hydroxylendgruppen (dyn. Visk. 20 ... 500 mPa.s) | 4,5 |
| III | Siliconharzlösung GE "PSA 529" | 8,2 |
| IV | Toluol | 6,8 |
| V | Benzin | 8,9 |
| VI | Ag-Pulver | 58,0 |

Wie Fig. 3 zeigt, ist dieses Matrixmaterial 25 mit den Ag-Partikeln 25a für eine Abschirmdichtung 23 auf einem Gehäuseabschnitt 21 mit kugelförmigen und ellispoidischen Thermoplast-Hohlkörpern 27 in einem Verhältnis von etwa 2 Volumenteilen Matrix und 1 Volumenteil Füllkörpern gefüllt, um die mittlere Dichte des Profils herabzusetzen und die Elastizitätseigenschaften, speziell den sogenannten compression-set, zu verbessern. Bei diesem Füllungsgrad ist noch eine hinreichend dichte Verteilung der Silberteilchen 25a im Gesamtvolumen und dadurch (im Zusammenhang mit der ausgreifenden Gestalt der Teilchen) die Ausbildung durchgehender Strompfade gewährleistet. Die gezeigte spezielle Form der Metallpartikel bindet sowohl diese wie auch die Hohlkörper, die durch die Metallteilchen gewissermaßen verankert werden, zudem fest in die Matrix ein.

In einer vierten Ausführung bestehen die Hohlkörper ausschließlich aus einer Ni- oder Ni/Ag-Metallhülle mit einer Wandungsdicke von 4 bis 5 µm und sind durch Aufbringung einer Metallschicht auf Kunststoffteilchen geeigneten Durchmessers und anschließende Entfernung des Kunststoffkerns durch Pyrolyse gebildet.

Die Bildung eines Abschirmprofils aus dem Kunststoffmaterial erfolgt bevorzugt auf die an sich bekannte, z.B. in der EP-B-0 629 114 grundsätzlich dargestellte Weise, je nach Einstellung der physikochemischen Eigenschaften ist aber ein Auftrag auf die abzuschirmenden Gehäuseteile auch durch Aufspritzen bzw. Aufsprühen oder Bestempeln möglich.

Die Erfindung beschränkt sich in ihrer Ausführung nicht auf die vorstehend angegebenen bevorzugten Ausführungsbeispiele.

Insbesondere sind in Abhängigkeit von den Anforderungen des konkreten Einsatzzwecks differenzierte Mischformen zwischen der Einbringung des Metalls in das Material ausschließlich als Beschichtung der Mikro-Hohlkörper und seiner Einbringung ausschließlich als Pulver - neben nicht leitfähigen Mikro-Hohlkörpern - realisierbar. Als Metallfüllung sind infolge der verringerten Einsatzmenge neben Silber verstärkt auch Gold, Platin oder Platinlegierungen einsetzbar.

Zusätzliche Optimierungsmöglichkeiten ergeben sich durch die Kombination mit einer leitfähigen, insbesondere rein metallischen, Oberflächenbeschichtung des erzeugten Kunststoffgegenstandes.

Als Matrix-Material sind neben Silikonmischungen Polyurethane, Epoxidharze, MDK oder andere bewährte Kunststoffe einsetzbar, die in jeweils spezifischer Weise als einoder mehrkomponentige Mischungen bereitzustellen und zu verarbeiten sind.

Der aus dem erfindungsgemäßen Material gebildete leitfähige Kunststoffgegenstand ist nicht nur als "form-in-place"oder "mold-in-place"-Abschirmdichtung, sondern auch als vorgefertigte Dichtung oder für andere Anwendungen im Bereich der Elektrotechnik und Elektronik einsetzbar.

## Patentansprüche

1. Kunststoffmaterial zur Herstellung eines leitfähigen Kunststoffgegenstandes, insbesondere zur Formung eines Abschirmprofils (3; 13; 23) in situ an einem Abschirmgehäuseteil (1; 11; 21), mit einer flüssigen oder pastösen, vernetzbaren oder hoch viskosen Kunstharzmatrix (5; 15; 25) und in der Kunstharzmatrix dispergierten, gasgefüllten Mikro-Hohlkörpern mit einer metallisch leitfähigen Hülle, wobei die Mikro-Hohlkörper elastisch kompressibel sind, **dadurch gekennzeichnet, dass** die Wandung der Mikro-Hohlkörper (7; 17; 27) einen Kunststoff aufweist und im Wesentlichen gasdicht ist.

2. Kunststoffmaterial nach Anspruch 1, **dadurch gekennzeichnet, daß** die mittlere Dichte der Mikro-Hohlkörper (7; 1 7; 27) nicht wesentlich größer ist als die Dichte der Kunstharzmatrix (5; 15; 25).

3. Kunststoffmaterial nach einem der vorstehenden Ansprüche, **dadurch gekennzeichnet, daß** die Mikro-Hohlkörper (7; 17; 27) einen Durchmesser im Bereich zwischen 5 µm und 100 µm, insbesondere zwischen 15 µm und 50 µm, haben.

4. Kunststoffmaterial nach einem der vorstehenden Ansprüche, **dadurch gekennzeichnet, daß** mindestens eine Teilmenge der Mikro-Hohlkörper (7; 27) hohlkugelförmig ist.

5. Kunststoffmaterial nach einem der vorstehenden Ansprüche, **dadurch gekennzeichnet, daß** mindestens eine Teilmenge der Mikrohohlkörper (17; 27) formanisotrop ist, insbesondere eine annähernd ellipsoidische, zylindrische oder prismatische Gestalt aufweist, wobei die Länge der größten Hauptachse eines Ellipsoids mindestens das 1,5-fache der nächstgrößeren Hauptachse bzw. die Zylinderhöhe mindestens das 1,5-fache des Radius bzw. die Höhe des Prismas mindestens das 1,5-fache der Länge von dessen größter Grundflächenseite beträgt, derart, daß das Kunststoffmaterial anisotrope mechanische und/oder elektrische oder thixotrope Eigenschaften hat.

6. Kunststoffmaterial nach einem der Ansprüche 3 bis 5, **dadurch gekennzeichnet, daß** die metallische Hülle (7a; 17a; 17b) im wesentlichen die gesamte Oberfläche der Mikro-Hohlkörper (7; 17) umfaßt.

7. Kunststoffmaterial nach einem der Ansprüche 3 bis 6, **dadurch gekennzeichnet, daß** die metallische Hülle der Mikro-Hohlkörper aus mindestens zwei Schichten (7a; 17b) besteht.

8. Kunststoffmaterial nach einem der Ansprüche 3 bis 7, **dadurch gekennzeichnet, daß** die metallische Hülle (7a; 17b) der Mikro-Hohlkörper eine rauhe Oberfläche, insbesondere mit einer im wesentlichen radial ausgerichteten Kristallitstruktur, hat.

9. Kunststoffmaterial nach einem der Ansprüche 3 bis 8, **dadurch gekennzeichnet, daß** die metallische Hülle (7a; 17a; 17b) der Mikro-Hohlkörper eine mittlere Dicke im Bereich zwischen 0,1 µm und 5 µm hat, wobei die mittlere Dicke auf die Abmessungen der Mikro-Hohlkörper so abgestimmt ist, daß die effektive Dichte der beschichteten Mikro-Hohlkörper nicht wesentlich größer ist als die der Kunststoffmatrix.

10. Kunststoffmaterial nach einem der vorstehenden Ansprüche, **gekennzeichnet durch** eine Kunstharzmatrix (5; 15; 25) auf Siliconbasis mit einem Anteil von nicht oder schwach vernetzendem Siloxan von mehr als 3 Masse-%.

11. Kunststoffmaterial nach einem der vorstehenden Ansprüche, **gekennzeichnet durch** einen Anteil von mehr als 3 Masse-% eines organischen Lösungsmittels im Ausgangsmaterial der Kunstharzmatrix.

12. Leitfähiger Kunststoffgeganstand aus einem Kunststoffmaterial nach einem der Ansprüche 1 bis 11, insbesondere ein freitragend durch Aufbringen eines solchen Kunststoffmaterials auf eine Fläche (1; 11; 21) eines Abschirmgehäuseteils gebildetes Abschirmprofil (3; 13; 23), **gekennzeichnet durch** eine homogene Verteilung der Mikro-Hohlkörper (7; 17; 27) in der Kunstharzmatrix (5; 15; 25).

13. Kunststoffgegenstand nach Anspruch 12, **gekennzeichnet durch** einen reversibel erzielbaren Deformationsgrad von über 30 %, insbesondere über 50 %, bezogen auf die Höhe eines unbelasteten U-förmigen Dichtungsprofils aus Vollmaterial.

14. Kunststoffgegenstand nach Anspruch 12 oder 13, **gekennzeichnet durch** eine mindestens partielle leitfähige Beschichtung, insbesondere in Verbindung mit einer nicht leitfähigen Füllung.

15. Kunststoffgegenstand nach einem der Ansprüche 12 bis 14, **gekennzeichnet durch** anisotrope mechanische und/oder elektrische Eigenschaften aufgrund einer Füllung mit in eine Vorzugsrichtung ausgerichteten formanisotropen Mikro-Hohlkörpern.

## Claims

1. A plastics material for producing a conductive plastics article, in particular for forming a shielding profile (3;13;23) in situ on a shielding housing part (11;11;21), with a fluid or pasty, cross-linkable or highly viscous synthetic resin matrix (5;15;25) and gas-filled micro hollow bodies dispersed in the synthetic resin matrix with a metallic conductive casing, wherein the micro hollow bodies are elastically compressible, **characterised in that** the walls of the micro hollow bodies (7;17;27) have a plastics material and are substantially gas-tight.

2. A plastics material according to Claim 1, **characterised in that** the average density of the micro hollow bodies (7;17;27) is not substantially greater than the density of the synthetic resin matrix (5;15;25).

3. A plastics material according to either one of the preceding Claims, **characterised in that** the micro hollow bodies (7;17;27) have a diameter in the range of between 5 µm and 100 µm, in particular 15 µm and 50 µm.

4. A plastics material according to any one of the preceding Claims, **characterised in that** at least a proportion of the micro hollow bodies (7;27) is of hollow spherical form.

5. A plastics material according to any one of the preceding Claims, **characterised in that** at least a proportion of the micro hollow bodies (7;27) is of anisotropic form, in particular has an approximately ellipsoidal, cylindrical or prismatic configuration, wherein the length of the largest major axis of an ellipsoid is at least 1.5 times the next largest major axis or the cylinder height is at least 1.5 times the radius or the height of the prism is at least 1.5 times the length of its maximum base area side so that the plastics material has anisotropic mechanical and/or electrical or thixotropic properties.

6. A plastics material according to any one of Claims 3 to 5, **characterised in that** the metallic casing (7a;17a;17b) substantially encloses the entire surface of the micro hollow bodies (7;17).

7. A plastics material according to Claim 3 to 6, **characterised in that** the metallic casing of the micro hollow bodies (7a;17b). comprises at least two layers (7a;17b).

8. A plastics material according to any one of Claims 3 to 7, **characterised in that** the metallic casing (7a;17b) of the micro hollow bodies has a rough surface, in particular with a substantially radially oriented crystallite structure.

9. A plastics material according to any one of Claims 3 to 8, **characterised in that** the metallic casing (7a;17a;17b) of the micro hollow bodies have an average thickness in the range of between 0.1 µm and 5 µm, wherein the average thickness is so adjusted to the dimensions of the micro hollow bodies that the effective density of the coated micro hollow bodes is not substantially greater than that of the synthetic material matrix.

10. A plastics material according to any one of the preceding Claims, **characterised by** a silicone-based synthetic resin matrix (5;15;25) with a proportion of non or weakly cross-linking siloxane of more than 3 % by weight.

11. A plastics material according to any one of the preceding Claims, **characterised by** a proportion of more than 3 % by weight of an organic solvent in the starting material of the synthetic resin matrix.

12. A conductive plastics material article consisting of a plastics material according to any one of Claims 1 to 11, in particular a shielding profile (3;13;23) formed self-supporting by applying such a plastics material to a surface (1;11;21) of a shielding housing part, **characterised by** a homogeneous distribution of the micro hollow bodies (7;17;27) in the synthetic resin matrix (5;15;25).

13. A plastics material article according to Claim 12, **characterised by** a degree of deformation, which can be obtained reversibly, of more than 30 %, in particular of more than 50 %, in relation to the height of an unladen U-shaped sealing profile of solid material.

14. A plastics material article according to Claim 12 or 13, **characterised by** an at least partly conductive coating, in particular in combination with a non-conductive filling.

15. A plastics material article according to any one of Claims 12 to 14, **characterised by** anisotropic mechanical and/or electrical properties based on a filling with micro hollow bodies of anisotropic form, which are oriented in a preferred direction.

## Revendications

1. Matière plastique pour fabriquer un objet conducteur en matière plastique, en particulier pour former sur site un profilé de blindage (3 ; 13 ; 23), sur une partie (1 ; 11 ; 21) d'un boîtier de blindage, avec une matrice en résine synthétique (5 ; 15 ; 25) liquide ou pâteuse, réticulable ou très visqueuse et des micro-corps creux remplis de gaz, dispersés dans la matrice de résine synthétique, avec une gaine métallique conductrice, les micro-corps creux étant élastiquement compressibles, **caractérisée en ce que** la paroi des micro-corps creux (7 ; 17 ; 27) présente une matière plastique et est sensiblement étanche aux gaz.

2. Matière plastique selon la revendication 1, **caractérisée en ce que** la densité moyenne des micro-corps creux (7 ; 17 ; 27) n'est sensiblement pas supérieure à la densité de la matrice en résine synthétique (5 ; 15 ; 25).

3. Matière plastique selon l'une des revendications précédentes, **caractérisée en ce que** les micro-corps creux (7 ; 17 ; 27) ont un diamètre compris entre 5 µm et 100 µm, en particulier entre 15 µm et 50 µm.

4. Matière plastique selon l'une des revendications précédentes, **caractérisée en ce qu'**au moins une quantité partielle des micro-corps creux (7 ; 27) a la forme de sphères creuses.

5. Matière plastique selon l'une des revendications précédentes, **caractérisée en ce qu'**au moins une quantité partielle des micro-corps creux (17 ; 27) a une forme anisotrope, en particulier une forme approximativement ellipsoidale, cylindrique ou prismatique, la longueur du plus grand axe principal d'un ellipsoïde représentant au moins 1,5 fois l'axe principal immédiatement plus grand, ou la hauteur du cylindre représentant au moins 1,5 fois le rayon ou la hauteur du prisme représentant au moins 1,5 fois la longueur du plus grand côté de sa base, de sorte que la matière plastique possède des propriétés anisotropes mécaniques et/ou électriques ou thixotropes.

6. Matière plastique selon l'une des revendications 3 à 5, **caractérisée en ce que** la gaine métallique (7a ; 17a ; 17b) entoure sensiblement toute la surface des micro-corps creux (7 ; 17).

7. Matière plastique selon l'une des revendications 3 à 6, **caractérisée en ce que** la gaine métallique des micro-corps creux est constituée d'au moins deux couches (17a ; 17b).

8. Matière plastique selon l'une des revendications 3 à 7, **caractérisée en ce que** la gaine métallique (7a ; 17b) des micro-corps creux présente une surface rugueuse, en particulier avec une structure de cristallite orientée sensiblement radialement.

9. Matière plastique selon l'une des revendications 3 à 8, **caractérisée en ce que** la gaine métallique (7a ; 17a ; 17b) des micro-corps creux présente une épaisseur moyenne comprise entre 0,1 µm et 5 µm, l'épaisseur moyenne étant adaptée aux dimensions des micro-corps creux de manière que la densité effective des micro-corps creux recouverts ne soit pas sensiblement supérieure à celle de la matrice en matière plastique.

10. Matière plastique selon l'une des revendications précédentes, **caractérisée par** une matrice en résine synthétique (5 ; 15 ; 25) à base de silicone avec une proportion de siloxane non réticulant ou faiblement réticulant supérieure à 3 % en masse.

11. Matière plastique selon l'une des revendications précédentes, **caractérisée par** une proportion de plus de 3 % en masse d'un solvant organique dans la matière première de la matrice en résine synthétique.

12. Objet conducteur en matière plastique constitué d'une matière plastique selon l'une des revendications 1 à 11, en particulier un profilé de blindage (3 ; 13 ; 23) formé en saillie par application de cette matière plastique sur une surface (1 ; 11 ; 21) d'une partie d'un boîtier de blindage, **caractérisé par** une distribution homogène des micro-corps creux (7 ; 17 ; 27) dans la matrice en résine synthétique (5 ; 15 ; 25).

13. Objet en matière plastique selon la revendication 12, **caractérisé par** un degré de déformation, pouvant être obtenu de manière réversible, supérieur à 30 %, en particulier supérieur à 50 %, par rapport à la hauteur d'un profilé d'étanchéité en U non sollicité, en un matériau plein.

14. Objet en matière plastique selon la revendication 12 ou 13, **caractérisé par** un revêtement conducteur au moins partiel, en particulier en combinaison avec un garnissage non conducteur.

15. Objet en matière plastique selon l'une des revendications 12 à 14, **caractérisé par** des propriétés anisotropes mécaniques et/ou électriques en raison d'un garnissage avec les micro-corps creux de forme anisotrope orientés dans une direction préférentielle.
